# FASCICULE DE BREVET EUROPEEN

(11) **EP 1 979 965 B1**
(45) Date de publication et mention de la délivrance du brevet: **16.09.2009**
(21) Numéro de dépôt: 07731497.9
(22) Date de dépôt: 15.01.2007
(51) Int. Cl.: H01M 4/92, H01M 4/86, H01M 4/88, H01M 8/10, C25B 11/04, B01J 23/652, C23C 16/18

(54) **CATHODE POUR RÉACTEUR ÉLECTROCHIMIQUE, RÉACTEUR ÉLECTROCHIMIQUE INTÉGRANT DE TELLES CATHODES ET PROCÉDÉ DE FABRICATION D'UNE TELLE CATHODE**
KATHODE FÜR EINEN ELEKTROCHEMISCHEN REAKTOR, ELEKTROCHEMISCHER REAKTOR MIT DERARTIGEN KATHODEN UND VERFAHREN ZUR HERSTELLUNG DIESER KATHODE
CATHODE FOR ELECTROCHEMICAL REACTOR, ELECTROCHEMICAL REACTOR INCORPORATING SUCH CATHODES AND METHOD FOR MAKING SAID CATHODE

(30) Priorité: 03.02.2006 FR 0650398
(43) Date de publication de la demande: 15.10.2008
(73) Titulaire: Commissariat à l'Energie Atomique, 75015 Paris (FR)
(72) Inventeur: MAILLEY, Sophie, 38730 Le Pin (FR); SANCHETTE, Frédéric, 38620 Montferrat (FR); THOLLON, Stéphanie, 38250 Saint Nizier Du Moucherotte (FR); EMIEUX, Fabrice, 38340 Voreppe (FR)
(74) Mandataire: Vuillermoz, Bruno
(86) Numéro de dépôt international: PCT/FR2007/050650
(87) Numéro de publication internationale: WO 2007/088291

(56) Documents cités:
- EP-A2- 1 175 948
- WO-A-03/015199
- WO-A-20/05001967
- JP-A- 2004 283 774
- US-A- 4 316 944
- US-A- 4 677 092
- G.A. BATTISTON ET AL.: "PLATINUM NANOELECTRODES EMBEDDED IN AN INSULATING ALUMINA MATRIX: AN INNOVATIVE APPROACH" CHEMICAL VAPOR DEPOSITION, vol. 11, no. 4, avril 2005 (2005-04), pages 187-190, XP001227865 ISSN: 0948-1907
- M.K. MIN ET AL.: "Particle size and alloying effects of Pt-based alloy catalysts for fuel cell applications" ELECTROCHIMICA ACTA, vol. 45, no. 25-26, 31 août 2000 (2000-08-31), pages 4211-4217, XP004227702 ISSN: 0013-4686

## Description

### DOMAINE TECHNIQUE

L'invention se rapporte à la réalisation de couche active de matériaux d'électrode pour réacteurs électrochimiques, tels que les piles à combustible et autres accumulateurs.

Plus précisément, l'invention concerne une cathode pour réacteur électrochimque présentant une surface active bi - ou multi-métallique, permettant de catalyser les réactions de réduction de l'oxygène, afin de réduire le taux de métaux nobles dans la structure.

L'immobilisation directe sur une structure métallique nanoporeuse de nanoparticules dispersées, est réalisée par co-déposition, sur des supports de couche de diffusion des gaz, de particules métalliques ou oxydes métalliques à l'aide du procédé DLI-MOCVD (« *Direct Liquid Metal Organic Chemical Vapor Deposition* »).

Cette immobilisation du catalyseur directement dans la matrice du matériau d'électrode permet de limiter les effets de perte du site catalytique liée à l'inaccessibilité des gaz ou du conducteur protonique, et, par un choix du co-métal, d'augmenter les propriétés de catalyse.

L'invention permet donc de diminuer les coûts liés à de fortes charges en catalyseur de métaux nobles et d'augmenter la stabilité en fonctionnement sous combustible issu du réformage.

### ETAT DE LA TECHNIQUE

Les analyses technico-économiques portant sur la viabilité des piles à combustible de type PEMFC (« *Proton Exchange Membrane Fuel Cell* »), montrent que l'avenir de cette technologie va être essentiellement déterminé par la réduction du coût du kW fourni par la pile et par la durée de vie de ses composants.

L'un des paramètres influant directement sur le coût des composants de pile provient du catalyseur. La plupart des catalyseurs efficaces pour les piles faibles températures sont des métaux nobles, tels que le platine (Pt) ou le ruthénium (Ru), qui sont très coûteux.

Ainsi, il a été estimé que le coût des catalyseurs dans la pile à combustible de type PEMFC correspond à 70 - 80% de la valeur totale du coeur de la pile.

L'état de l'art dans la réalisation des matériaux d'électrodes préconise le dépôt par spray, peinture ou enduction d'une encre constituée de particules catalytiques métalliques supportées sur des particules de carbone et d'un solvant organique. De telles électrodes sont par exemple décrits dans les documents EP-A-0 872 906 et EP-A-0 928 036.

JP 2004 283774 A divulgue un procédé de fabrication d'un catalyseur pour pile à combustible dans lequel des nanoparticules de RuO₂ sont déposées sur un support à base de platine et de carbone pour obtenir un nanocatalyseur de type bimétallique Pt-RuO₂ dispersé sur du carbone.

Un procédé de préparation de nanoélectrodes de platine comprenant une matrice d'alumine (Al₂O₃) est décrit par G.A. Battiston et coll. dans Chemical VaporDeposition, vol. 11, no. 4, avril 2005, pages 187-190. Ce procédé comprend une étape unique de déposition simultanée via MOCVD du matériau de platine et de la matrice d'alumine.

WO 2005/001967 A divulgue des catalyseurs multimétalliques pour pile à combustible comprenant du platine, du chrome ainsi que du cuivre, du nickel ou une combinaison de ces derniers, avec différentes proportions de chacun de ces métaux.

EP-A2-1 175 948 décrit un procédé de préparation de nanoparticules contenant des métaux nobles tels que le platine, éventuellement en combinaison avec d'autres métaux tels que le chrome.

US-A-4 677 092 et US-A-4 316 944 divulguent des alliages binaires et ternaires de type Pt-Cr et Pt-Cr-Co, respectivement, utilisés comme catalyseurs pour piles à combustible. M.K. Min et coll. dans Electrochimica Acta, vol. 45, no. 25-26, 31 août 2000, pages 4211-4217, décrivent la préparation et les propriétés physiques et électrochimiques d'électrocatalyseurs à base de platine sous forme d'alliage binaire de type Pt-M (avec M = Co, Cr ou Ni) déposés sur un support de carbone.

L'utilisation de particules catalytiques immobilisées sur carbone permet d'obtenir des particules catalytiques nanométriques tout en réduisant la charge catalytique. Cependant, le procédé de fabrication des particules supportées par le carbone requiert généralement des températures élevées (T > 300°C), qui conduisent à une coalescence des particules métalliques. Par ailleurs, les catalyseurs supportés sur carbone présentent l'inconvénient d'être parfois perdus dans les pores nanométriques du carbone, ce qui les rend inactifs dans la couche active de l'électrode. Le taux de platine déposé, constituant la couche active optimisée, est de l'ordre de 0,35 mg/cm². Cette valeur est trop importante en termes de coût, les études commerciales envisageant des taux de platine dans la pile proches d'une valeur inférieure à 0,1 mg/cm².

De plus, si l'on considère les couches actives utilisant C/Pt, il est estimé que seulement 50 à 75% du platine fixé est électroactif. La perte en activité du platine est liée essentiellement à des ruptures sur les réseaux de conduction électronique ou protonique, à l'apport des espèces réactives dans le matériau d'électrode (réseau de diffusion des gaz) et à l'inactivité des particules catalytiques perdues dans les pores du carbone.

Des méthodes de réalisation par électrodéposition par CCVD (décrite dans le document WO 03/015199) ou par *« ion - beam* » (décrite dans le document US - 6 673 127) ont révélé la possibilité d'immobiliser directement le catalyseur en surface des matériaux de couche de diffusion pour parer aux inconvénients des dépôts par spray de platine supporté par le carbone. Cependant, ces technologies donnent lieu à des couches actives non satisfaisantes, par exemple en raison d'une taille excessive des particules ou une pénétration insuffisante de ces particules dans la couche de diffusion.

Il existe donc un besoin évident de réaliser des couches catalytiques pour réacteurs électrochimiques, et notamment pour piles à combustible de type PEMFC, permettant d'éviter d'immobiliser de fortes charges de catalyseur, susceptibles de rester inaccessible au réseau de conduction protonique et de diffusion des gaz, ou bloquantes pour la conduction électronique.

### DESCRIPTION DE L'INVENTION

Dans le cadre de la présente invention, le Demandeur s'est orienté vers une autre approche, à savoir la diminution du taux de platine dans la couche active d'une cathode en couplant l'action du catalyseur constitué de métal noble à un autre métal ayant une plus faible action catalytique ou ne jouant qu'un rôle favorable pour l'absorption d'espèce à catalyser.

Ainsi et selon un premier aspect, l'invention concerne une cathode pour réacteur électrochimique présentant des nanoparticules bi - métalliques ou multi -métalliques, dispersées en contact direct avec la couche de diffusion, l'un des métaux au moins se présentant en tout ou en partie sous forme oxydée.

Selon l'invention, l'un des métaux est un catalyseur fort de type métal noble, avantageusement du platine (Pt).

Au moins un autre des métaux est un métal moins coûteux, à plus faible activité catalytique ou simplement impliqué dans la capture de l'espèce à catalyser. Le chrome (Cr) s'est avéré particulièrement adapté à la mise en oeuvre de l'invention. C'est ce dernier qui se présente sous forme oxydée en tout ou en partie.

Il était certes connu de l'art antérieur d'utiliser du chrome comme catalyseur pour des piles hautes températures ou éventuellement dans des alliages. Cependant, le chrome mis en oeuvre était supporté par le carbone (Cf. WO 99/53557).

Cette association permet de diminuer significativement la charge en platine à une valeur inférieure ou égale à 0,2 mg/cm², les cathodes ainsi réalisées présentant des qualités électrochimiques remarquables.

La couche de diffusion présente avantageusement une structure nanoporeuse. Elle est préférentiellement constituée de carbone poreux, intégrant éventuellement du conducteur protonique comme le Nafion^{®}. Le carbone poreux peut se présenter sous la forme de graphite ou de nanotubes.

La couche catalytique est constituée de particules de dimension nanométrique, de diamètre inférieur à 100 nm, préférentiellement compris entre 1 et 50 nm, associant intimement au moins deux métaux.

De telles structures ont pu être obtenues grâce à la mise en oeuvre du procédé DLI-MOCVD. Ainsi et selon un second aspect, l'invention concerne un procédé de fabrication de cathodes pour réacteurs électrochimiques présentant des nanoparticules bi -métalliques ou multi - métalliques, dispersées en contact direct avec la couche de diffusion, dans lequel l'étape de dépôt du catalyseur sur la couche de diffusion est réalisée par DLI-MOCVD.

Seule cette technologie permet de réaliser de manière satisfaisante une structure dans laquelle les particules catalytiques sont directement fixées sur le support de matériau de la cathode, la couche de diffusion des gaz. Ainsi, la zone de catalyse correspond effectivement au domaine dénommé point de contact triple, où viennent prendre place les échanges électroniques, la consommation de réactif gazeux et le transfert d'espèces ioniques.

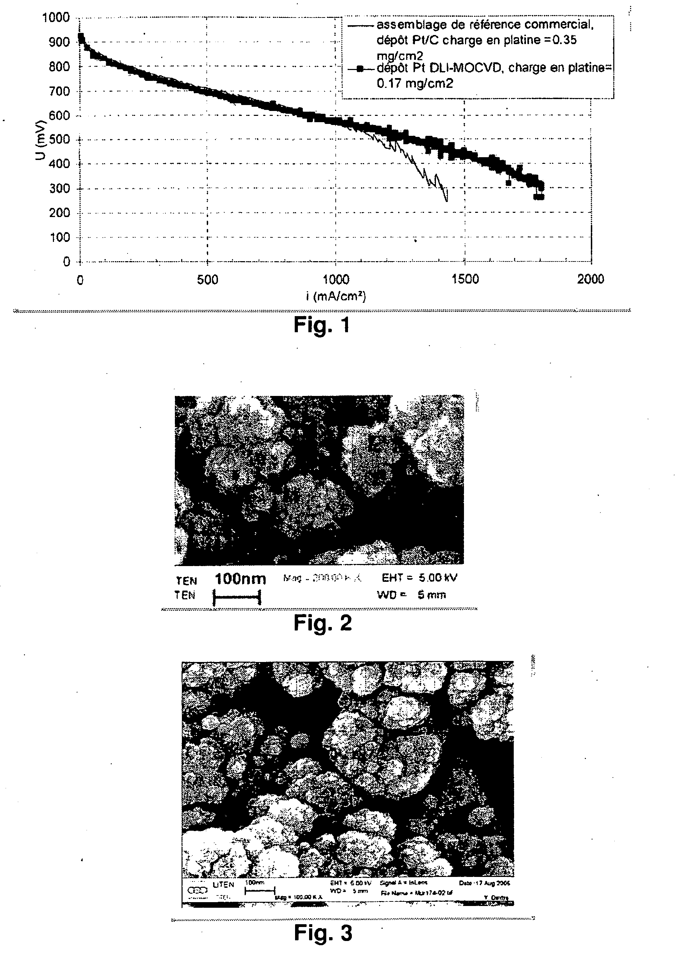

A ce titre, la figure 1 illustre l'avantage de cette technologie avec le seul catalyseur Pt par rapport à du platine supporté sur du carbone tel que décrit dans l'art antérieur.

En outre et selon l'invention, il y a co - dépôt d'au moins deux métaux par le procédé DLI-MOCVD.

Le principe de la DLI-MOCVD est issu des systèmes classiques de CVD (« *Chemical Vapor Deposition »).* Les espèces réactives sont apportées sous forme liquide et injectées à haute pression par les injecteurs. Ainsi, partant d'une solution de précurseur dilué, la consommation en produit est réduite et peut être contrôlée en volume ou en masse.

En pratique, la synthèse de ces nanoparticules bi-métalliques ou multi-métalliques est réalisée par DLI-MOCVD à pression atmosphérique ou sous vide, avec une température de dépôt inférieure ou égale à 400°C, à partir d'un mélange de précurseurs tels que les organo-métalliques (type β-diacétonates, carboxylates) solubles dans un solvant commun (acétyl acétone, THF, ...), ou à partir de plusieurs sources indépendantes de précurseurs dans différents solvants, en présence d'un gaz réactionnel composé en majorité d'un gaz réactif oxydant (par exemple O₂, CO₂...) ou réducteur (H₂).

Ce procédé de réalisation autorise une vitesse de croissance rapide et contrôlable. En outre, il peut être réalisé avec assistance plasma permettant un contrôle continu des espèces injectées.

Les co - dépôts réalisés par DLI-MOCVD offrent une morphologie propre aux particules bi-métalliques, notamment Pt-Cr, ou multi-métalliques.

En effet, le dépôt obtenu par cette technologie peut se présenter sous différentes formes suivant le mode de germination et de croissance des composés mis en jeu. Le fait d'utiliser des injecteurs haute pression permet d'avoir une spécificité de la morphologie du dépôt lié à la possibilité d'apporter des espèces réactives plus rapidement. Cette spécificité de morphologie est aussi liée au choix du substrat utilisé.

Plus particulièrement, l'oxyde de chrome formé par dépôt DLI-MOCVD montre une structure en mousse dense sur le microporeux (figure 2).

En revanche, le dépôt de platine seul se présente sous la forme d'îlots métalliques de taille nanométrique (de 1 à 50 nm de diamètre) bien dispersés en surface du support (couche de diffusion) avec une distance interparticulaire de 1 à 50 nm (figure 3).

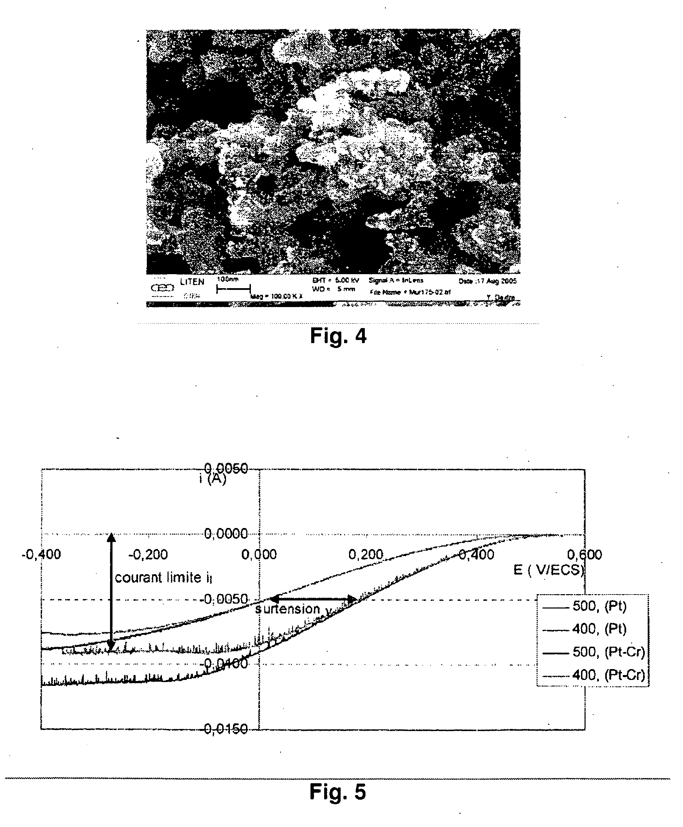

La réalisation en simultané des dépôts d'oxyde de chrome et de platine permet d'augmenter fortement le volume géométrique des particules catalytiques de platine dans une structure 3D apportée par l'oxyde de chrome (figure 4). Les propriétés intrinsèques du chrome permettent par ailleurs de faciliter l'adsorption de l'oxygène.

Les caractérisations par électrochimie montrent une diminution de la surtension d'électrode pour la réaction de réduction de l'oxygène (figure 5). Les structures bi-métalliques ou multi-métalliques selon l'invention permettent donc de diminuer la surtension d'électrode et d'améliorer les performances de la pile. Il en résulte une amélioration des propriétés de cinétique de catalyse de la réduction d'électrode à oxygène.

De par la nature chimique des particules déposées (métaux nobles et oxydes métalliques) et de la morphologie des dépôts (grand nombre de sites actifs de taille nanométrique très bien dispersés), les couches actives mises en oeuvre dans le cadre de l'invention apparaissent comme hautement performantes pour l'électrocatalyse des réactions générées au sein des réacteurs électrochimiques.

Les piles à combustible et les accumulateurs intégrant de telles cathodes font également partie de l'invention.

### EXEMPLES DE REALISATION

L'invention et les avantages qui en découlent ressortiront mieux des exemples de réalisation qui suivent, à l'appui des figures annexées. Ces exemples ne sont toutefois en aucun cas limitatifs.
- Figure 1 :: Courbe de polarisation comparant les performances en pile d'une électrode avec C/Pt et une électrode avec comme catalyseur du platine déposé par DLI-MOCVD.
- Figure 2 :: Microscopie de l'interface de dépôt de chrome obtenu par DLI-MOCVD sur GDL E-tek.
- Figure 3 :: Microscopie de l'interface d'électrode modifiée par un dépôt Pt-Cr par DLI-MOCVD sur GDL E-tek.
- Figure 4 :: Microscopie de l'interface d'électrode modifiée par un dépôt Pt sur GDL E-tek.
- Figure 5 :: Courbes de polarisation des performances en réduction de l'oxygène d'une électrode Pt-Cr et d'une électrode Pt.
- Figure 6 :: Performances en pile de couches Pt ou Pt-oxyde de Cr, déposées sous air ou sous oxygène, utilisées comme cathodes.

Les exemples présentés ci-dessous ont été réalisés à l'aide d'un dispositif de vaporisation commercialisé par la Société JIPELEC sous le nom de *"Inject, Système d'injection et d'évaporation de précurseurs liquides purs ou sous forme de solutions",* couplé à une enceinte de dépôt chimique en phase vapeur.

Le dispositif JIPELEC comprend plusieurs parties : le réservoir de stockage de la solution chimique, un injecteur (essence, diesel) relié au réservoir de liquide par une ligne d'alimentation et piloté par un dispositif de commande électronique, une ligne d'alimentation de gaz vecteur, et un dispositif de vaporisation (évaporateur).

L'enceinte de dépôt, qui contient le substrat à revêtir, comprend un système de chauffage, une alimentation de gaz et des moyens de pompage et de régulation de pression.

L'enceinte de dépôt ainsi que le substrat sont portés à une température supérieure à celle de l'évaporateur, de façon à créer un gradient thermique positif. La solution chimique est introduite dans le réservoir maintenu sous pression (2 bars dans le cas présent), puis envoyée au travers du ou des injecteurs par différence de pression dans l'évaporateur. Le débit d'injection est contrôlé en fréquence et en temps d'ouverture par l'injecteur.

Pour les exemples de dépôt ci-dessous, les nanoparticules de platine (Pt) sont réalisées sur substrat de couche de diffusion commerciale de type ELAT (produit E-Tek, commercialisé par De Nora). Les solutions chimiques de dépôt comprennent les précurseurs organo-métalliques, respectivement dans le toluène pour le Cr(CO)₆ et dans le xylène pour le Pt(COD). Les températures de l'évaporateur et du substrat sont fixées respectivement à 140 et 290°C. Les autres conditions opératoires des exemples sont présentées dans le tableau I suivant :

**Tableau 1 : Conditions opératoires appliquées pour les essais**

| | Concentration Mol/l | Fréquence injecteur (Hz) ; Inj 1(Pt)/inj2 (Cr) | Temps d'ouverture injecteur (ms) | Débits N2/O2 (cc) | Pression (Pas) | Temps de dépôts (min) |
|---|---|---|---|---|---|---|
| Essai 1: dépôt de Pt seul | 0.025 | 2/0 | 2 | 40/160 | 800 | 30 |
| Essai 2: Dépôt de Cr seul | 0.02 | 0/4 | 2 | 40/160 | 800 | 30 |
| Essai 3 : Dépôt de Pt-Cr | 0,025 M (Pt(COD)), 0,02 M (Cr(CO)₆) | 2/4 | 2 | 40/160 | 800 | 30 |

Les dépôts réalisés par DLI-MOCVD sur une couche de diffusion E-tek ont été visualisés par microscopie. Les images correspondantes sont présentées sur les figure 2 (Cr, essai 2), 3 (Pt-Cr, essai 3) et 4 (Pt, essai 1), respectivement.

Les courbes de réduction d'électrode à oxygène présentées à la figure 5 ont été réalisées sur des cathodes selon l'invention, à savoir présentant une structure métallique nanoporeuse incorporant des particules nanométriques nanodispersées de catalyseur, déposées par le procédé DLI-MOCVD.

Ces courbes révèlent une diminution de la surtension de réaction de réduction d'électrode à oxygène de 200 mV. Le courant limite de réaction est plus important sur les électrodes bi-métalliques (Pt-Cr, essai 3), par rapport à la structure monométallique (Pt, essai 1). Ces résultats indiquent une plus grande dispersion du catalyseur noble actif et l'amélioration des phénomènes de cinétique catalytique par la présence d'oxyde de chrome.

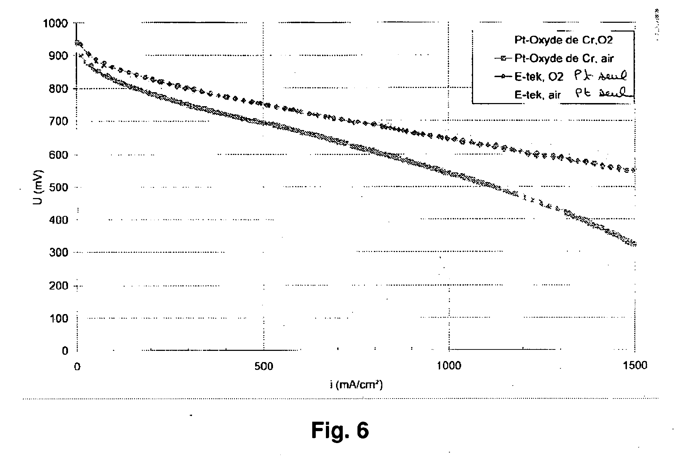

La figure 6 illustre les résultats obtenus en pile avec différentes couches utilisées comme cathode. On constate que des couches de référence E-tek contenant du platine seul, à hauteur de 0,35 mg/cm², donnent des résultats équivalents à des couches selon l'invention, contenant un mélange oxyde de chrome et platine à hauteur de 0,089 mg/cm², et ce qu'il s'agisse d'un dépôt sous air ou sous oxygène. La présence de chrome oxydé permet donc de diminuer significativement la charge en métal noble coûteux.

## Revendications

1. Cathode pour réacteur électrochimique comprenant une couche de diffusion et une couche catalytique, ***caractérisée* en ce qu'**elle présente des nanoparticules bi-métalliques ou multi-métalliques, dispersées en contact direct avec la couche de diffusion, et **en ce que** l'un des métaux au moins est du chrome (Cr) se présentant en tout ou en partie sous forme oxydée.

2. Cathode pour réacteur électrochimique selon la revendication 1, ***caractérisée* en ce que** l'un des métaux au moins est un catalyseur, préférentiellement du platine (Pt).

3. Cathode pour réacteur électrochimique selon la revendication 2, ***caractérisée* en ce que** la charge en platine sur la couche de diffusion est inférieure ou égale à 0,2 mg/cm²_{.}

4. Cathode pour réacteur électrochimique selon l'une des revendications 1 à 3, ***caractérisée* en ce que** la couche de diffusion est réalisée en carbone poreux.

5. Cathode pour réacteur électrochimique selon la revendication 4, ***caractérisée* en ce que** le carbone poreux est constitué de nanotubes de carbone.

6. Cathode pour réacteur électrochimique selon l'une des revendications 1 à 5, ***caractérisée* en ce que** le diamètre des nanoparticules de catalyseur est inférieur à 100 nm, préférentiellement compris entre 1 et 50 nm.

7. Pile à combustible comprenant au moins une cathode selon l'une des revendications 1 à 6.

8. Accumulateur comprenant au moins une cathode selon l'une des revendications 1 à 6.

9. Procédé de fabrication d'une cathode pour réacteur électrochimique selon l'une des revendications 1 à 6, ***caractérisé* en ce que** l'étape de dépôt du catalyseur sur la couche de diffusion de la cathode est réalisée par procédé DLI-MOCVD.

10. Procédé de fabrication d'une cathode pour réacteur électrochimique selon la revendication 9, ***caractérisé* en ce que** les métaux entrant dans la constitution du catalyseur sont co - déposés.

11. Procédé de fabrication d'une cathode pour réacteur électrochimique selon la revendication 10, ***caractérisé* en ce que** les précurseurs des métaux sont dissous dans des solvants.

12. Procédé de fabrication d'une cathode pour réacteur électrochimique selon l'une des revendications 9 à 11, ***caractérisé* en ce que** le dépôt du catalyseur est réalisé à une température inférieure à 400°C.

13. Procédé de fabrication d'une cathode pour réacteur électrochimique selon l'une des revendications 9 à 12, ***caractérisé* en ce que** le dépôt par DLI-MOCVD est réalisé avec assistance plasma.

## Claims

1. Cathode for electrochemical reactor comprising a diffusion layer and a catalyst layer, ***characterized* in that** it has bimetallic or multimetallic nanoparticles, dispersed in direct contact with the diffusion layer, and **in that** at least one of the metals is chromium (Cr) wholly or partly in oxidized form.

2. Cathode for electrochemical reactor according to Claim 1, ***characterized* in that** at least one of the metals is a catalyst, preferably platinum (Pt).

3. Cathode for electrochemical reactor according to Claim 2, ***characterized* in that** the platinum load on the diffusion layer is not more than 0.2 mg/cm².

4. Cathode for electrochemical reactor according to one of Claims 1 to 3, ***characterized* in that** the diffusion layer is made from porous carbon.

5. Cathode for electrochemical reactor according to Claim 4, ***characterized* in that** the porous carbon consists of carbon nanotubes.

6. Cathode for electrochemical reactor according to one of Claims 1 to 5, ***characterized* in that** the diameter of the catalyst nanoparticles is lower than 100 nm, preferably between 1 and 50 nm.

7. Fuel cell comprising at least one cathode according to one of Claims 1 to 6.

8. Storage battery comprising at least one cathode according to one of Claims 1 to 6.

9. Method for fabricating a cathode for electrochemical reactor according to one of Claims 1 to 6, ***characterized* in that** the step of depositing the catalyst on the diffusion layer of the cathode is carried out by the DLI-MOCVD process.

10. Method for fabricating a cathode for electrochemical reactor according to Claim 9, ***characterized* in that in that** the metals included in the constitution of the catalyst are co-deposited.

11. Method for fabricating a cathode for electrochemical reactor according to Claim 10, ***characterized* in that** the metal precursors are dissolved in solvents.

12. Method for fabricating a cathode for electrochemical reactor according to one of Claims 9 to 11, ***characterized* in that** the catalyst is deposited at a temperature lower than 400°C.

13. Method for fabricating a cathode for electrochemical reactor according to one of Claims 9 to 12, **characterized in that** the deposition by DLI-MOCVD is plasma enhanced.

## Patentansprüche

1. Kathode für einen elektrochemischen Reaktor, die eine Diffusionsschicht und eine katalytische Schicht umfasst, **dadurch gekennzeichnet, dass** sie zwei oder mehr Metalle aufweisende Nanopartikel aufweist, die in direktem Kontakt mit der Diffusionsschicht fein verteilt sind, und dass mindestens eines der Metalle Chrom (Cr) ist, das sich insgesamt oder zum Teil in oxidierter Form darstellt.

2. Kathode nach Anspruch 1, für einen elektrochemischen Reaktor, **dadurch gekennzeichnet, dass** mindestens eines der Metalle ein Katalysator, vorzugsweise Platin (Pt) ist.

3. Kathode nach Anspruch 2, für einen elektrochemischen Reaktor, **dadurch gekennzeichnet, dass** die Platinbeschickung auf der Diffusionsschicht kleiner oder gleich 0,2 mg/cm² ist.

4. Kathode nach einem der Ansprüche 1 bis 3, für einen elektrochemischen Reaktor, **dadurch gekennzeichnet, dass** die Diffusionsschicht aus porösem Kohlenstoff hergestellt ist.

5. Kathode nach Anspruch 4, für einen elektrochemischen Reaktor, **dadurch gekennzeichnet, dass** der poröse Kohlenstoff aus Kohlenstoff-Nanoröhren besteht.

6. Kathode nach einem der Ansprüche 1 bis 5, für einen elektrochemischen Reaktor, **dadurch gekennzeichnet, dass** der Durchmesser der Katalysator-Nanopartikel kleiner als 100 nm ist, vorzugsweise zwischen 1 und 50 nm beträgt.

7. Brennstoffzelle mit mindestens einer Kathode nach einem der Ansprüche 1 bis 6.

8. Akkumulator mit mindestens einer Kathode nach einem der Ansprüche 1 bis 6.

9. Verfahren zur Herstellung einer Kathode nach einem der Ansprüche 1 bis 6, für einen elektrochemischen Reaktor, **dadurch gekennzeichnet, dass** der Schritt des Abscheidens des Katalysators auf die Diffusionsschicht der Kathode durch das Verfahren DLI-MOCVD erfolgt.

10. Verfahren nach Anspruch 9, zur Herstellung einer Kathode für einen elektrochemischen Reaktor, **dadurch gekennzeichnet, dass** die Metalle, die an der Ausbildung des Katalysators beteiligt sind, kombiniert abgeschieden werden.

11. Verfahren nach Anspruch 10, zur Herstellung einer Kathode für einen elektrochemischen Reaktor, **dadurch gekennzeichnet, dass** die Vorstufen der Metalle in Lösungsmitteln gelöst sind.

12. Verfahren nach einem der Ansprüche 9 bis 11, zur Herstellung einer Kathode für einen elektrochemischen Reaktor, **dadurch gekennzeichnet, dass** die Abscheidung des Katalysators bei einer Temperatur unter 400°C erfolgt.

13. Verfahren nach einem der Ansprüche 9 bis 12, zur Herstellung einer Kathode für einen elektrochemischen Reaktor, **dadurch gekennzeichnet, dass** die Abscheidung durch DLI-MOCVD mit Hilfe von Plasma erfolgt.
